# EUROPEAN PATENT APPLICATION

(11) **EP 4 343 831 A1**
(43) Date of publication of application: **27.03.2024**
(21) Application number: 22306413.0
(22) Date of filing: 25.09.2022
(51) Int. Cl.: H01L 23/482, H01L 23/66, H01L 23/522

(54) **FIELD EFFECT TRANSISTOR WITH INTEGRATED SERIES CAPACITANCE**

(71) Applicant: Wolfspeed, Inc., Durham, NC 27703 (US)
(72) Inventor: FISHER, Jeremy, Raleigh, 27614 (US); BOUISSE, Gerard, 31470 Saint-Lys (FR)
(74) Representative: Boult Wade Tennant LLP

(57) **Abstract**

A radio frequency (RF) transistor die includes a semiconductor structure having an active region including a plurality of transistors having respective gate, drain, or source fingers, and manifold on the semiconductor structure that electrically couples a plurality of the respective gate, drain, or source fingers. At least one capacitor is on the manifold and/or is on at least one of the respective gate, drain, or source fingers. The manifold may be a first metal layer on the semiconductor structure that provides a lower plate of the at least one capacitor, and a second metal layer on the semiconductor structure may provide an upper plate of the at least one capacitor. Related devices and fabrication methods are also discussed.

## Description

### FIELD

The present disclosure is directed to integrated circuit ("IC") devices, and more particularly, to power amplifier devices, device packaging, and related fabrication methods.

### BACKGROUND

Electrical circuits requiring high power handling capability while operating at high frequencies, such as 0.5-1 GHz, 3 GHz, and 10 GHz or more, have in recent years become more prevalent. In particular, there is now a high demand for radio frequency ("RF") power amplifiers that are used to amplify RF signals at radio (including microwave) frequencies in a variety of applications, such as base stations for wireless communication systems, etc. The signals amplified by the RF power amplifiers often include signals that have a modulated carrier having frequencies in the megahertz (MHz) to gigahertz (GHz) range. These RF power amplifiers may need to exhibit high reliability, good linearity, and handle high output power levels.

Many RF power amplifier designs utilize semiconductor switching devices as amplification devices. Examples of these switching devices include power transistor devices, such as field effect transistor (FET) devices including MOSFETs (metal-oxide semiconductor field-effect transistors), DMOS (double-diffused metal-oxide semiconductor) transistors, HEMTs (high electron mobility transistors), MESFETs (metal-semiconductor field-effect transistors), LDMOS (laterally-diffused metal-oxide semiconductor) transistors, etc.

RF transistor amplifiers are typically formed as semiconductor integrated circuit chips. Most RF transistor amplifiers are implemented in silicon or using wide bandgap semiconductor materials (i.e., having a band-gap greater than 1.40 eV), such as silicon carbide ("SiC") and Group III nitride materials. As used herein, the term "Group III nitride" refers to those semiconducting compounds formed between nitrogen and the elements in Group III of the periodic table, usually aluminum (Al), gallium (Ga), and/or indium (In). The term also refers to ternary and quaternary compounds, such as AlGaN and AlInGaN. These compounds have empirical formulas in which one mole of nitrogen is combined with a total of one mole of the Group III elements.

RF transistor amplifiers may include one or more amplification stages, with each stage typically implemented as a transistor amplifier. In order to increase the output power and current handling capabilities, RF transistor amplifiers are typically implemented in a "unit cell" configuration in which a large number of individual "unit cell" transistor structures are arranged electrically in parallel. An RF transistor amplifier may be implemented by transistor cells of a single integrated circuit chip or "die," or may include a plurality of dies. A die or chip may refer to a small block of semiconducting material or other substrate on which electronic circuit elements are fabricated. When multiple RF transistor amplifier dies are used, they may be connected in series and/or in parallel.

Silicon-based RF transistor amplifiers are typically implemented using LDMOS transistors, and can exhibit high levels of linearity with relatively inexpensive fabrication. Group III nitride-based RF amplifiers are typically implemented using HEMTs, primarily in applications requiring high power and/or high frequency operation where LDMOS transistor amplifiers may have inherent performance limitations.

In operation of HEMT devices, a two-dimensional electron gas (2DEG) is formed at the heterojunction of two semiconductor materials with different bandgap energies, where the smaller bandgap material has a higher electron affinity. The 2DEG is an accumulation layer in the smaller bandgap material and can contain a very high sheet electron concentration. Additionally, electrons that originate in the wider-bandgap semiconductor material transfer to the 2DEG layer, allowing high electron mobility due to reduced ionized impurity scattering. This combination of high carrier concentration and high carrier mobility can give the HEMT a very large transconductance and may provide a strong performance advantage over metal oxide semiconductor field effect transistors (MOSFETs) for high-frequency applications. High electron mobility transistors fabricated in Group III-nitride based material systems also have the potential to generate large amounts of radio frequency (RF) power because of the combination of material characteristics that includes the aforementioned high breakdown fields, wide bandgaps, large conduction band offset, and/or high saturated electron drift velocity.

RF transistor amplifiers often include matching circuits or circuitry, such as (i) impedance matching circuits, which are designed to improve the impedance match between the active transistor die (e.g., including MOSFETs, HEMTs, LDMOS, etc.) and transmission lines connected thereto for RF signals at the fundamental operating frequency, and (ii) harmonic termination circuits that are designed to at least partly terminate harmonic products that may be generated during device operation, such as second and third order harmonics. The termination of the harmonic products also influences generation of baseband intermodulation distortion products.

The transistor die(s) as well as the impedance matching and harmonic termination circuits may be enclosed in a device package. Integrated circuit packaging may refer to encapsulating one or more dies in a supporting case or package that protects the dies from physical damage and/or corrosion, and supports the electrical contacts for connection to external circuits. Electrical leads may extend from the package to electrically connect the transistor die to external systems and/or circuit elements such as input and output RF transmission lines and bias voltage sources. The input and output matching circuitry in an integrated circuit device package typically include LC networks that provide at least a portion of an impedance matching circuit that is configured to match the impedance of the active transistor die to a fixed value. Typically, the input and output RF matching circuitry employ off-die components and implementations, which may increase the package footprint and/or parasitic inductance between components.

### SUMMARY

According to some embodiments, a transistor die includes a semiconductor structure comprising an active region including a plurality of transistors having respective gate, drain, or source fingers; a manifold on the semiconductor structure that electrically couples a plurality of the respective gate, drain, or source fingers; and at least one capacitor on the manifold and/or on at least one of the respective gate, drain, or source fingers.

In some embodiments, RF input, RF output, and ground terminals are provided on the semiconductor structure, where one of the RF input, RF output, and ground terminals is electrically connected to the manifold. The at least one capacitor is electrically coupled in series with the respective one of the RF input, RF output or ground terminals free of a wirebond connection.

In some embodiments, the manifold is a portion of a metal layer on the semiconductor structure that provides one of an upper or lower plate of the at least one capacitor.

In some embodiments, the at least one capacitor comprises a dielectric layer having a thickness of about 0.01 to about 1 micrometer (µm) between the upper plate and the lower plate thereof.

In some embodiments, the manifold is a drain manifold that electrically couples the plurality of the respective drain fingers to the RF output terminal, and the at least one capacitor is electrically coupled in series with the RF output terminal.

In some embodiments, the at least one capacitor is on at least one of a first portion of the drain manifold that extends adjacent a periphery of the active region, or a second portion of the drain manifold that extends over the active region along ones of the respective drain fingers.

In some embodiments, the manifold is a gate manifold that electrically couples the plurality of the respective gate fingers to the RF input terminal, and the at least one capacitor is electrically coupled in series with the RF input terminal.

In some embodiments, the manifold includes a first metal layer on the semiconductor structure and provides a lower plate of the at least one capacitor. An upper plate of the at least one capacitor includes a second metal layer on the manifold.

In some embodiments, one or more conductive pillars protrude from the upper plate of the at least one capacitor on the manifold.

In some embodiments, the upper plate of the at least one capacitor is configured to provide a wire bond pad on the manifold.

In some embodiments, the RF input or RF output terminal includes one or more conductive bond pads on the manifold adjacent a periphery of the active region.

In some embodiments, the ground terminal includes a source pad that is electrically coupled to the plurality of the respective source fingers, and the at least one capacitor includes a shunt capacitor that is electrically coupled between the manifold and the source pad.

In some embodiments, the shunt capacitor includes a lower plate that is electrically connected to the source pad, and an upper plate that is electrically connected to the one or more conductive bond pads on the manifold.

In some embodiments, a first metal layer on the semiconductor structure provides the lower plate of the shunt capacitor, and a second metal layer on the semiconductor structure provides the upper plate of the shunt capacitor.

In some embodiments, a shunt inductance element electrically couples the upper plate of the shunt capacitor to the one or more conductive bond pads on the manifold.

In some embodiments, the shunt inductance element comprises one or more conductive transmission lines on the semiconductor structure.

In some embodiments, the at least one capacitor includes a first capacitor on the semiconductor structure electrically coupled between the RF input terminal and the ground terminal, and a second capacitor on the semiconductor structure and electrically coupled in series with the RF input terminal.

In some embodiments, a first shunt inductance element is electrically coupled between the RF input terminal and the first capacitor.

According to some embodiments, a transistor die includes a semiconductor structure having first and second metal layers thereon and a dielectric layer between the first and second metal layers. The semiconductor structure includes a plurality of transistors having respective gate, drain, and source fingers. The first metal layer is on at least one of or electrically couples a plurality of the respective gate, drain, or source fingers and provides a lower plate of at least one capacitor, and the second metal layer provides an upper plate of the at least one capacitor.

In some embodiments, the dielectric layer has a thickness of about 0.01 to about 1 micrometer (µm) between the upper plate and the lower plate of the at least one capacitor.

In some embodiments, the lower plate is a drain manifold that electrically couples the plurality of the respective drain fingers to an RF output terminal on the semiconductor structure such that the at least one capacitor is on the drain manifold and electrically coupled in series with the RF output terminal.

In some embodiments, the at least one capacitor is on at least one of a first portion of the drain manifold that extends adjacent a periphery of an active region of the semiconductor structure, or a second portion of the drain manifold that extends over the active region along respective ones of the drain fingers.

In some embodiments, the lower plate is a gate manifold electrically couples the plurality of the respective gate fingers to an RF input terminal on the semiconductor structure such that the at least one capacitor is on the gate manifold and electrically coupled in series with the RF input terminal.

In some embodiments, one or more conductive pillars protrude from the upper plate of the at least one capacitor.

In some embodiments, the upper plate of the at least one capacitor is configured to provide a wire bond pad.

In some embodiments, the first metal layer includes one or more conductive bond pads on or adjacent a periphery of an active region of the semiconductor structure. The conducive bond pads provide RF input or RF output terminals for the transistor die.

In some embodiments, the lower plate electrically couples the plurality of the respective source fingers to a ground terminal on the semiconductor structure such that the at least one capacitor is a shunt capacitor that is electrically coupled between the ground terminal and the one or more conductive bond pads.

In some embodiments, a shunt inductance element electrically couples the upper plate of the shunt capacitor to the one or more conductive bond pads.

In some embodiments, the shunt inductance element includes one or more conductive transmission lines on the semiconductor structure.

According to some embodiments, a method of fabricating transistor die includes providing a semiconductor structure comprising a plurality of transistors having respective gate, drain, and source fingers; forming a first metal layer on the semiconductor structure, where the first metal layer is on at least one of or electrically couples a plurality of the respective gate, drain, or source fingers and provides a lower plate of at least one capacitor; forming a dielectric layer on the first metal layer; and forming a second metal layer on the dielectric layer, where the second metal layer provides an upper plate of the at least one capacitor.

In some embodiments, the dielectric layer has a thickness of about 0.01 to about 1 micrometer (µm) between the upper plate and the lower plate of the at least one capacitor.

In some embodiments, the lower plate is a drain manifold that electrically couples the plurality of the respective drain fingers to an RF output terminal on the semiconductor structure such that the at least one capacitor is on the drain manifold and electrically coupled in series with the RF output terminal.

In some embodiments, the at least one capacitor is on at least one of a first portion of the drain manifold that extends adjacent a periphery of an active region of the semiconductor structure, or a second portion of the drain manifold that extends over the active region along respective ones of the drain fingers.

In some embodiments, the lower plate is a gate manifold that electrically couples the plurality of the respective gate fingers to an RF input terminal on the semiconductor structure such that the at least one capacitor is on the gate manifold and electrically coupled in series with the RF input terminal.

In some embodiments, the method further includes forming or otherwise providing one or more conductive pillars protruding from the upper plate of the at least one capacitor.

In some embodiments, the method further includes providing one or more wirebond connections to the upper plate of the at least one capacitor.

In some embodiments, the first metal layer includes one or more conductive bond pads adjacent a periphery of an active region of the semiconductor structure, which provide RF input or RF output terminals.

In some embodiments, the lower plate electrically couples the plurality of the respective source fingers to a ground terminal on the semiconductor structure such that the at least one capacitor comprises a shunt capacitor that is electrically coupled between the ground terminal and the one or more conductive bond pads.

In some embodiments, the method further includes providing a shunt inductance element that electrically couples the upper plate of the shunt capacitor to the one or more conductive bond pads.

In some embodiments, the shunt inductance element includes one or more conductive transmission lines on the semiconductor structure.

In some embodiments, the semiconductor structure may include one or more epitaxial layers of a wide bandgap semiconductor material.

In some embodiments, the semiconductor structure may include a Group-III nitride material on a silicon carbide substrate.

In some embodiments, the semiconductor structure may comprise silicon.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the invention, and be protected by the accompanying claims.

### BRIEF DESCRIPTION OF THE DRAWINGS

FIG. 1A is a schematic plan view of a RF transistor amplifier die or device according to some embodiments of the present disclosure.
FIG. 1B is a schematic cross sectional view of a unit cell of the RF transistor amplifier die or device of FIG. 1A.
FIG. 2A is a schematic plan view of a RF transistor amplifier die or device including on-chip capacitors integrated on the drain pad or manifold according to some embodiments of the present disclosure.
FIGS. 2B, 2C, 2D, and 2E are schematic cross sectional views taken along line II-II' of FIG. 2A, illustrating examples of wirebond or conductive pillar connections to on-chip capacitors according to some embodiments of the present disclosure.
FIG. 3A is a schematic plan view of a RF transistor amplifier die or device including on-chip capacitors integrated on internal portions of the drain manifold between gate fingers according to some embodiments of the present disclosure.
FIGS. 3B and 3C are schematic cross sectional views taken along lines IIIb-IIIb' and IIIc-IIIc' of FIG. 3A, respectively, illustrating examples of wirebond or conductive pillar connections to on-chip capacitors according to some embodiments of the present disclosure.
FIG. 4 is a schematic plan view of a RF transistor amplifier die or device including on-chip capacitors integrated on the drain manifold and on internal portions of the drain manifold between gate fingers according to some embodiments of the present disclosure.
FIG. 5A is a schematic plan view of a RF transistor amplifier die or device including on-chip capacitors integrated on edges or corner portions of the die and electrically connected to the source pad according to some embodiments of the present disclosure.
FIG. 5B is a schematic cross sectional view taken along lines V-V' of FIG. 5A.
FIG. 6 is a schematic plan view of a RF transistor amplifier die or device including on-chip capacitors integrated on edges or corner portions of the die and electrically connected to the gate pad and/or the drain pad by inductance elements according to some embodiments of the present disclosure.
FIG. 7 is a schematic plan view of a RF transistor amplifier die or device including on-chip capacitors integrated on the drain pad or manifold, on internal portions of the drain manifold between gate fingers, and on edges or corner portions of the die according to some embodiments of the present disclosure.
FIG. 8A is a schematic plan view of a RF transistor amplifier die or device including on-chip capacitors integrated on the gate and drain pads or manifolds according to some embodiments of the present disclosure.
FIGS. 8B, 8C, 8D, and 8E are schematic cross sectional views taken along line VIII-VIII' of FIG.8A, illustrating examples of wirebond or conductive pillar connections to on-chip capacitors according to some embodiments of the present disclosure.
FIG. 9 is a schematic plan view of a RF transistor amplifier die or device including on-chip series capacitors integrated on the gate and drain pads or manifolds and on-chip shunt capacitors integrated on edges or corner portions of the die and electrically connected to the gate pad and/or the drain pad by inductance elements according to some embodiments of the present disclosure.
FIG. 10 is an equivalent circuit diagram of the gate connections of FIG. 9, illustrating an input matching circuit implemented by on-chip series and shunt capacitors and inductances according to some embodiments of the present disclosure.
FIG. 11 is a flowchart illustrating methods of fabricating an RF transistor die according to some embodiments of the present invention.

### DETAILED DESCRIPTION OF EMBODIMENTS

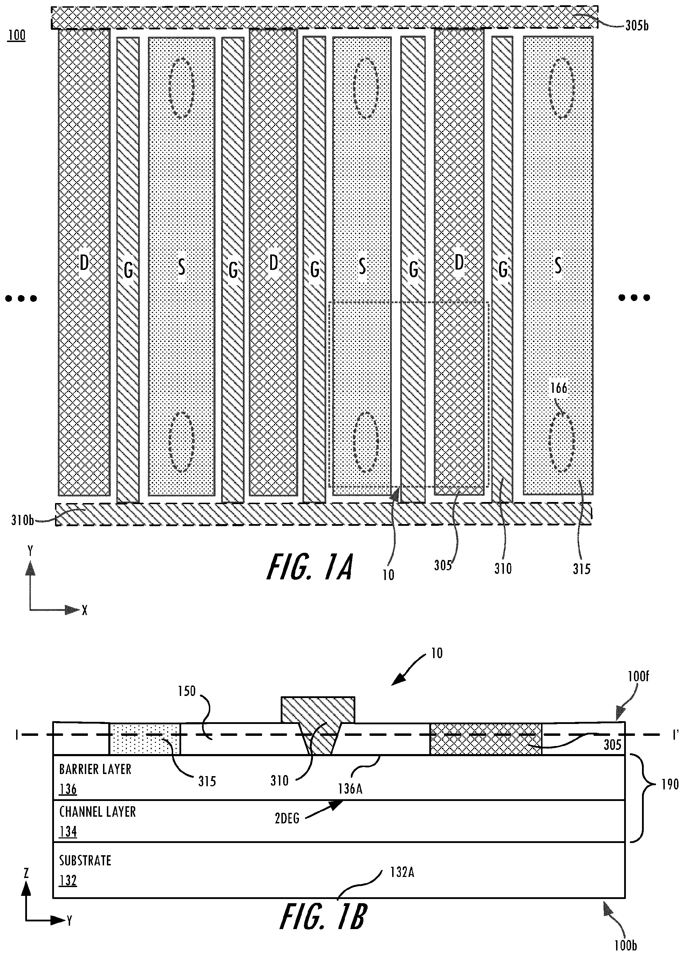

Some power amplifier configurations described herein may be implemented using a plurality of "unit cell" transistors that are fabricated on a common semiconductor die, with a plurality of the unit cells defining each transistor amplifier device. Each unit cell transistor may include a source region, a drain region and a channel region in a semiconductor material, with the channel region being between the source and drain regions. A gate electrode or terminal (or "gate"), which may be implemented as an elongated gate finger, is formed above the channel region and extends in parallel between source and drain contacts, as is schematically illustrated in FIG. 1A.

FIG. 1A is a schematic plan view of a portion of a semiconductor transistor die 100 according to embodiments of the present disclosure. The transistor die 100 may include transistor cells of a power transistor device, for example, an RF power amplifier. FIG. 1B is a schematic cross-sectional view of a unit cell transistor structure 10 (also referred to herein as a transistor structure or transistor cell) of the device 100. The plan view of FIG. 1A is taken along line I-I' of FIG. 1B. While described herein primarily with reference to high electron mobility transistors ("HEMTs") by way of example, it will be understood that embodiments of the present disclosure are not limited to any particular transistor type, and may include, for example, metal-oxide-semiconductor field effect transistor (MOSFET) embodiments, such as laterally diffused MOSFETs (LDMOS) embodiments.

As will be understood by one of ordinary skill in the art, the transistor cell 10 (e.g., a HEMT, MOSFET, LDMOS, etc.) may be defined by the active region between a source contact 315 and a drain contact 305 under the control of a gate contact 310. In some embodiments, the source contact 315, the drain contact 305, and the gate contact 310 may be formed as a plurality of source contacts 315, drain contacts 305, and gate contacts 310 alternately arranged on a semiconductor structure 190, with a gate contact 310 disposed between adjacent drain contacts 305 and source contacts 315 to form a plurality of transistor unit cells 10, as illustrated in FIG. 1A. Hundreds or thousands of unit cells, such as unit cell 10, may be formed on the semiconductor structure 190 and may be electrically connected in parallel to provide the RF transistor amplifier die or device 100.

In the examples of FIGS. 1A and 1B, the transistor die 100 may include multiple transistor cells 10 with respective contacts connected in parallel to provide off-chip connections (e.g., input, output, or ground connections). For example, as shown in FIG. 1A, each of the gate 310, drain 305, and source 315 contacts may extend in a first direction (e.g., the Y-direction) to define gate G, drain D, and/or source S 'fingers,' which in some embodiments may be connected by one or more optional buses (e.g., by a gate bus 310b and a drain bus 305b; shown in phantom in FIG. 1A) and/or wirebond connection pads coupled thereto on or adjacent an upper or front surface 100f of the die 100.

The gate fingers G, drain fingers D, and source fingers S (and connecting buses and wirebond connection pads) may define part of gate-, drain-, and source-connected electrodes of the transistor die 100, respectively, which in some embodiments may be defined by one or more top or frontside metal layers (e.g., M1 metallization, M2 metallization), to which conductive pillars or wire bonds described herein may be coupled. The metal layers may define pads (e.g., 315s, 310g, 305d herein) or manifolds (e.g., 321g, 321d herein) that electrically connect multiple gate fingers G, multiple drain fingers D, or multiple source fingers S. Dielectric layer(s) 150 isolate the various conductive elements of the frontside metallization structure from each other. Since the gate fingers G are electrically connected together, the drain fingers D are electrically connected together, and the source fingers S are electrically connected together, it can be seen that the unit cell transistors 10 are all electrically connected together in parallel.

In some embodiments, one of the terminals of the respective unit cell transistors 10 of the transistor die 100 (e.g., the gate contact 310) may provide an input signal connection that is configured to be coupled to an RF input signal. One of the terminals of the respective unit cell transistors 10 (e.g., the drain contact 305) may provide an output signal connection that is configured to output an RF output signal. One of the terminals of the respective unit cell transistors 10 of the transistor die 100 (e.g., the source contact 315) may provide a ground connection that is configured to be coupled to a reference signal such as an electrical ground. In RF IC designs that may require a backside ground plane, conductive through substrate vias 166 may be used to connect the backside ground plane to the source contact 315. That is, RF input (e.g., gate), RF output (e.g., drain), or ground (e.g., source) contact pads or terminals of the die 100 may be directly or indirectly connected to corresponding terminals of one or more transistor cells 10 (e.g., gate 310, drain 305, and/or source 315 terminals of a FET, such as a HEMT or LDMOS transistor) of the die 100, for example, by respective metal contacts.

Some power amplifier matching circuits (e.g., for broadband RF applications or Doherty applications) may benefit from having a series capacitor connected immediately or directly with the input (e.g., the gate terminal) and/or the output (e.g., the drain terminal) of a transistor die. A direct current (DC) blocking capacitor may be provided between the RF input lead and the gate to isolate the RF input lead from gate bias signals. As noted above, such capacitors may be typically implemented by components that are external to the transistor die, also referred to as "off-chip" or off-die. However, connecting off-chip capacitance necessarily introduces series inductance between the transistor and the capacitor, which can reduce the achievable bandwidth of the matching circuit.

Embodiments of the present disclosure may arise from realization that some challenges may be addressed by implementing capacitors (and, in some embodiments, inductance elements) on-chip, i.e., on the semiconductor structure of the transistor die itself, for example, utilizing metal layers that are stacked on or adjacent the active region. For example, one or more series capacitors may be integrated into a conductive pad or manifold (which may be electrically connected to the gate bus 310b, drain bus 305b, or source pad) of the transistor die itself, which may further reduce parasitic inductance. The capacitors can be implemented as series (e.g., DC blocking) capacitors and/or shunt (e.g., DC bypass) capacitors. In some embodiments, the capacitor(s) may be metal-insulator-metal capacitors (MIMCAPs) with the upper and/or lower capacitor plates implemented by one or more metallization layers (e.g., M1, M2) of the transistor die with a dielectric layer therebetween, and electrically connected to RF input, RF output, or ground terminals of the transistor die 100. Implementing a capacitor coupled in series to the drain terminal on-die may also retain the ability to bias the transistor (e.g., by coupling a shunt inductance) at the drain terminal. The upper metallization layer (e.g., M2) may also implement input and/or output bond pads (e.g., 310g, 305d) directly on the lower metallization layer (e.g., M1) without the dielectric layer therebetween.

In some embodiments, one or more wirebond-based interconnects may be used to provide electrical connections to input, output, or ground terminals, and/or to the capacitors coupled thereto. Additionally or alternatively, in some embodiments, one or more conductive-pillar-based interconnects may be used to provide electrical connections to input, output, or ground terminals, and/or to the capacitors coupled thereto. The conductive-pillar-based interconnects may allow for a "flip-chip" die configuration, in which pads or terminals of the transistor die are implemented on an upper surface or top side of the transistor die (i.e., adjacent the active region) and the die is configured to be mounted on a printed circuit board (PCB) or other substrate face-down and electrically connected by conductive bumps or pillars, rather than by wirebonds. That is, on-die capacitor implementations in accordance with embodiments of the present disclosure may include layouts that are compatible with wire bond and/or flip chip configurations of the transistor die.

In contrast, conventional discrete transistor dies may not incorporate series capacitors directly coupled to input, output, or ground connections on the die itself. Rather, matching elements are typically realized off-chip and require electrical connections to the die (e.g. by bond wires), which may increase inductance and impose bandwidth limitations.

Embodiments are described below with reference to example RF transistor dies 200, 300, 400, 500, 600, 700, 800, 900. The transistor dies 200-900 may each include a semiconductor structure 190 (e.g., including one or more epitaxial layers) as shown in FIG. 1B. The semiconductor structure 190 includes an active region with a plurality of transistors 10. RF input, RF output, and ground terminals are provided on the semiconductor structure 190 and are electrically connected to respective terminals 310, 305, 315 of the transistors 10, for example, by a pad (e.g., 315s) or manifold (e.g., 321g, 321d) that electrically connects multiple fingers (e.g., G, D, or S) of the transistors 10. At least one capacitor 330, 330', 330" is provided on the semiconductor structure 190. For example, the capacitor(s) 330, 330', 330" may include or may be defined by respective portions of first and second metal layers 331, 332 on the semiconductor structure 190, with a dielectric layer 333 therebetween. For example, the semiconductor structure 190 may include a plurality of transistors having respective gate G, drain D, and source S fingers, the first metal layer 331 (or portions thereof) may be electrically coupled to multiple of the respective gate G, drain D, or source S fingers and may provide a lower plate 3301, 3301', 3301" of a respective capacitor 330, 330', 330", and the second metal layer 332 (or portions thereof) may provide an upper plate 330u, 330u', 330u" of the respective capacitor 330.

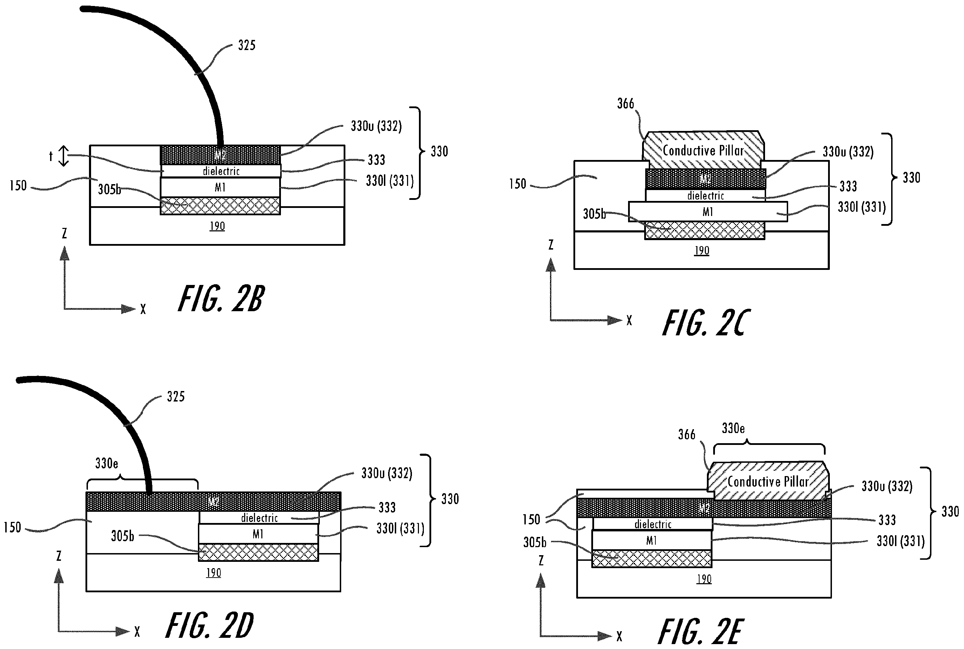

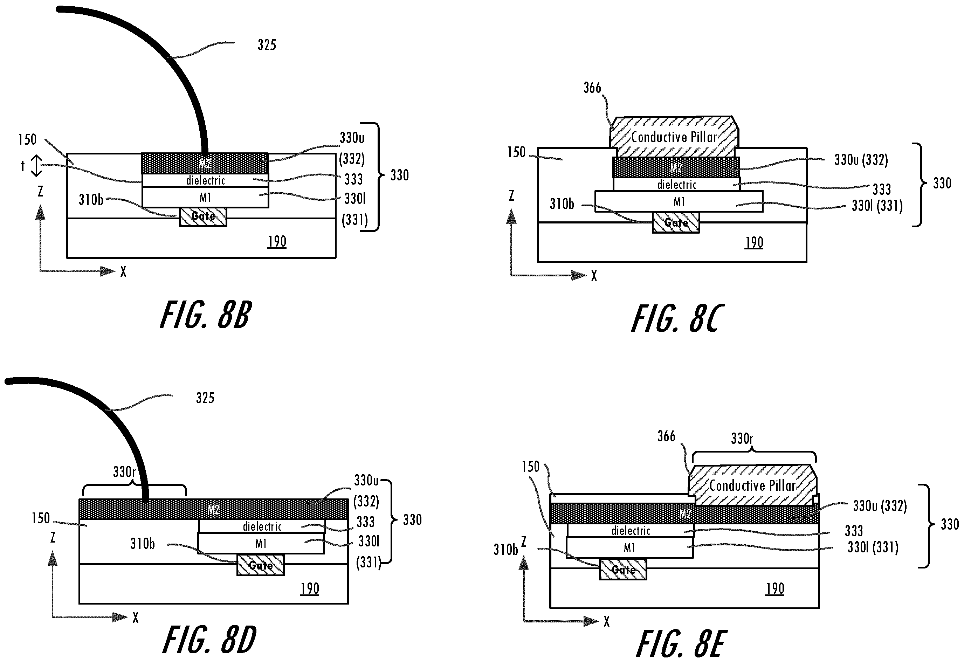

The capacitor(s) 330, 330', 330" may respectively include a dielectric layer 333 (shown for example in FIGS. 2B-2E and 8B-8E) between the upper plate 330u, 330u', 330u" and the lower plate 3301, 3301', 3301" thereof. Although shown as separate layers (e.g., M1 and 310b, 305b, or 315), it will be understood that the lower plate 3301, 3301', 3301" of a respective capacitor 330, 330', 330" and the portion of the gate 310, drain 305, or source 315 may be implemented as a single layer or as multiple layers in various embodiments, and may include ohmic layers or portions that contact the semiconductor structure 190. Similarly, the respective fingers (e.g., D, S) may be implemented as portions of the same metal layer (e.g., M1). Likewise, it will be understood that the upper (e.g., M2) plate 330u, 330u', 330u", the dielectric layer 333, and the lower plate 3301, 3301', 3301" of a respective capacitor 330, 330', 330" may be aligned or may overlap by various amounts in the vertical (e.g., Z-) direction, in addition or as an alternative to the amounts of overlap of these elements specifically shown.

The capacitor dielectric layer 333 may be silicon oxide (SiₓO_{y}), silicon nitride (SiₓN_{y}), silicon oxynitrides (SiₓO_{y}N_{z}), and/or other suitable dielectric materials. The capacitor dielectric layer 333 may be of a same material as, but may differ in thickness from, one or more insulating or dielectric layers that are formed on the semiconductor structure 190 (e.g., as interlayer insulating layers or passivation layers). The capacitor dielectric layer 333 may also include high-k materials (e.g., Al₂O₃, HfO₂, TiO₂, La₂O₃ and ZrO₂ or composites thereof), which may differ from the interlayer insulating or passivation layers. The capacitor dielectric layer 333 may have a thickness t of less than about 1 µm, for example, about 0.1 µm to 1 µm, between the upper plate 330u, 330u', 330u" and the lower plate 3301, 3301', 3301" of a respective capacitor 330, 330', 330". In some embodiments, the capacitor dielectric layer 333 may be an ALD film, having a thickness, for example, of about 0.01 µm to 1 µm.

The capacitors 330, 330', 330" may be configured to provide a capacitance ranging from about 0.01 to 10 picofarads (pF). For example, the gate or drain manifold-based capacitors 330 or the shunt capacitors 330" may be configured to provide a capacitance ranging from about 0.1 to about 50 pF, for example about 0.2 to about 30 pF. The drain finger-based capacitors 330' may be configured to provide a capacitance ranging from about 0.01 to about 2 pF, for example about 0.05 to about 1 pF.

The capacitor(s) 330, 330', 330" may thereby be configured to provide a desired capacitance that is integrated on the semiconductor structure 190 of the respective transistor dies 200-900 on the active region (e.g., as drain finger-based capacitors 330') or adjacent an edge or periphery of the active region (e.g., as gate or drain manifold-based capacitors 330 or shunt capacitors 330"), and can be respectively coupled to any of the RF input, RF output, or ground terminals of the respective transistor dies 200-900 free of wirebond connections. For example, as described in greater detail herein, the RF input terminal (e.g., bond pads 310g), the RF output terminal (e.g., bond pads 305d), or the ground terminal (e.g., source pads 315s) may be electrically coupled to a respective portion of a metal layer 331, 332 on the semiconductor structure 190, and an upper plate 330u, 330u', 330u" or lower plate 3301, 3301', 3301" of the capacitor(s) 330, 330', 330" may be defined by the respective portion of the metal layer 331 or 332. The respective capacitor(s) 330, 330', 330" can thus be electrically coupled in series with the RF input terminal 310g, the RF output terminal 305d, or the ground terminal on the die 200-900 itself and without parasitic inductance therebetween, which may provide on-chip matching circuits and/or harmonic termination circuits, such as shunt circuits, to improve RF performance.

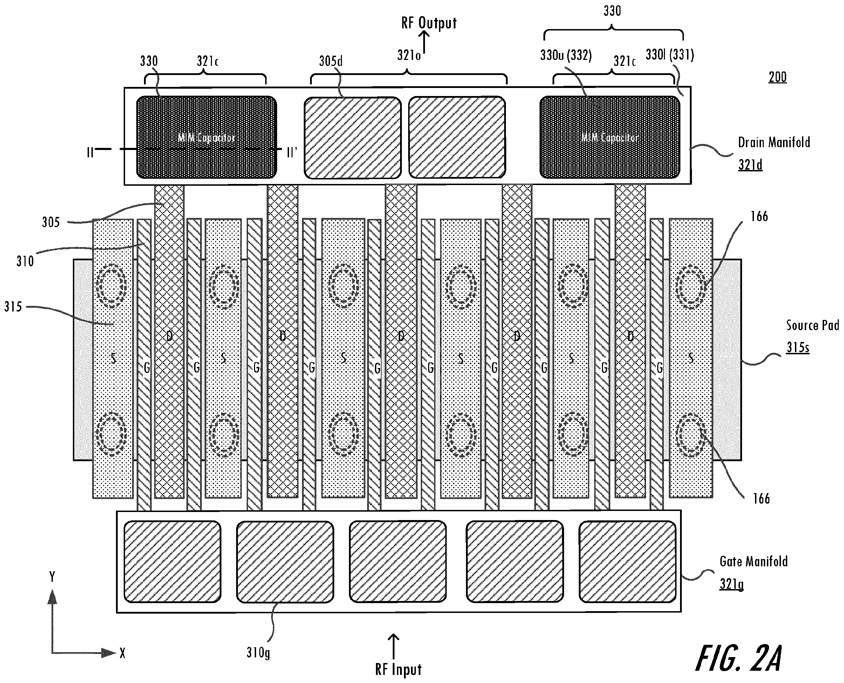

In FIGS. 2A to 9, the transistor dies 200-900 include gate 310, drain 305, and source 315 contacts that extend in a first direction (e.g., the Y-direction) to define interdigitated gate G, drain D, and source S fingers (similar to the die 100 of FIGS. 1A-1B). In these examples, the gate G, drain D, and source S fingers provide RF input signal, RF output signal, and ground connections, respectively, but it will be understood that other connections may be possible. A gate manifold 321g electrically couples the gate fingers G to an RF input terminal (shown as multiple input bond pads 310g). A drain manifold 321d electrically couples the drain fingers D to an RF output terminal (shown as multiple output bond pads 305d). A source pad 315s electrically couples the source fingers S and provides a ground terminal that is configured to be coupled to an electrical ground.

FIG. 2A is an example schematic plan view of a RF transistor die or device 200 including on-chip capacitors 330 integrated on drain pads 305d or manifold 321d according to some embodiments of the present disclosure. As shown in FIG. 2A, the drain manifold 321d includes two sections 321o and 321c. The first section 321o (also referred to as an output bond pad area) includes the output bond pads 305d, which provide a direct electrical connection to a first metal layer 331 (e.g., M1) of the drain manifold 321d. The output bond pads 305d may be used to provide a DC coupled path for bias and/or shunt element connections (further explained herein). The second section 321c includes one or more on-chip capacitors 330 (shown as MIMCAPs, each including an upper plate 330u, a dielectric layer 333, and a lower plate 3301), where portions of a second metal layer 332 (e.g., M2) provide the respective upper plates 330u of the capacitors 330, portions of the first metal layer 331 provide the respective lower plates 3301 of the capacitors, with the respective dielectric layers 333 (not visible in FIG. 2A) between the upper plates 330u and the lower plates 3301. The upper plate 330u may provide (or may be electrically coupled to) a bond pad for direct connection to a respective capacitor 330, and the lower plate 3301 may be electrically connected to the drain (e.g., to the drain bus 305b), providing a series capacitance at the RF output terminal of the transistor die 200.

The capacitors 330 are thus integrated on the drain manifold 321d, such that the drain manifold 321d provides a lower plate 3301 of the capacitors 330 in the second section 321c, while the first section 321o provides the output bond pads 305d. In the example of FIG. 2A, the drain manifold 321d extends adjacent a periphery of the active region of the semiconductor structure 190, and the on-chip capacitors 330 are thus likewise stacked adjacent a periphery of the active region, on or adjacent the output bond pads 305d. However, the capacitors 330 may extend onto (or may be confined outside of) the active region in some embodiments. More generally, the position and/or size of the drain manifold 321d, each section 321o, 321c thereof, and/or the number of capacitor(s) 330 thereon (and thus the collective capacitance value provided thereby) may vary in accordance with embodiments of the present disclosure to provide a desired capacitance and/or routing of connections.

FIGS. 2B, 2C, 2D, and 2E are schematic cross sectional views taken along line II-II' of FIG. 2A, illustrating examples of electrical connections to on-chip capacitors 330 electrically coupled in series with an RF output terminal of a transistor die 200 according to some embodiments of the present disclosure. In FIGS. 2B to 2E, the on-chip capacitors 330 may each include a lower plate 3301, an upper plate 330u, and a dielectric layer 333 therebetween. In the examples of FIGS. 2B to 2E, the lower plate 3301 is implemented by portions of a first metal layer 331 on the semiconductor structure 190, and the upper plate is implemented by portions of a second metal layer 332 on the semiconductor structure 190. The capacitors 330 are configured for electrical connection to an external (or "off-chip") device using wirebonds 325 and/or conductive pillars 366.

For example, a wirebond 325 may be directly bonded to the upper plate 330u of the capacitor 330 as shown in FIG. 2B, or may be bonded to an extension pad 330e (or an adjacent bond pad 305d) that is an electrically connected to the upper plate 330u, as shown in FIG. 2D. Additionally or alternatively, a conductive pillar 366 or other type of integrated connector may be directly bonded to the upper plate 330u of the capacitor 330 as shown in FIG. 2C, or may be bonded to an extension pad 330e that is an electrically connected to the upper plate 330u, as shown in FIG. 2E. The extension pad 330e may be implemented by a portion of the second metal layer 332, and may be integral to the upper plate 330u in some embodiments. Embodiments described herein may include various combinations of conductive pillars 366 and wirebond 325 connections.

Bonding directly to the upper plate 330u of the capacitor 330 (whether by wirebond 325 or conductive pillar 366) may allow for fewer bond pads, thereby reducing device size and cost. The conductive pillar connections 366 shown in FIGS. 2C and 2E may be relatively thick conductive plated structures in some embodiments. For example, the conductive pillars 366 may be Cu - or other metal-plated structures. The conductive pillars 366 may allow for mounting of transistor dies described herein in a "flip-chip" configuration, where the transistor die is flipped upside-down and attached and electrically connected to a substrate or other external device by the pillars 366 adjacent the frontside 100f of the semiconductor structure 190. As such, bond wires may not be required for the connections, which may reduce an amount of inductance present in the circuit and thus reduce parasitic effects relating to the package and connections.

The electrical connections shown in FIGS. 2B to 2E, may be used to implement on-chip matching and/or harmonic termination circuits at the RF output terminal of the die 200 in some embodiments. For example, a series inductance may be coupled to the capacitor 330 to provide an LC circuit at the RF output of the transistor die for matching and/or shunt circuits. The series inductance may be implemented by a wirebond 325 (as shown in FIGS. 2B and 2D) or a conductive pillar 366 (as shown in FIGS. 2C and 2E), either directly to the upper plate 330u (as shown in FIGS. 2B and 2C) or to the extension pad 330e (as shown in FIGS. 2D and 2E). In some embodiments, the wirebonds 325 may be routed relative to the direction of extension of the fingers G, D, S so as to provide an orthogonal shunt inductance, which may reduce coupling with series inductances. The wirebonds 325 and/or pillars 366 may be configured to provide a desired inductance value.

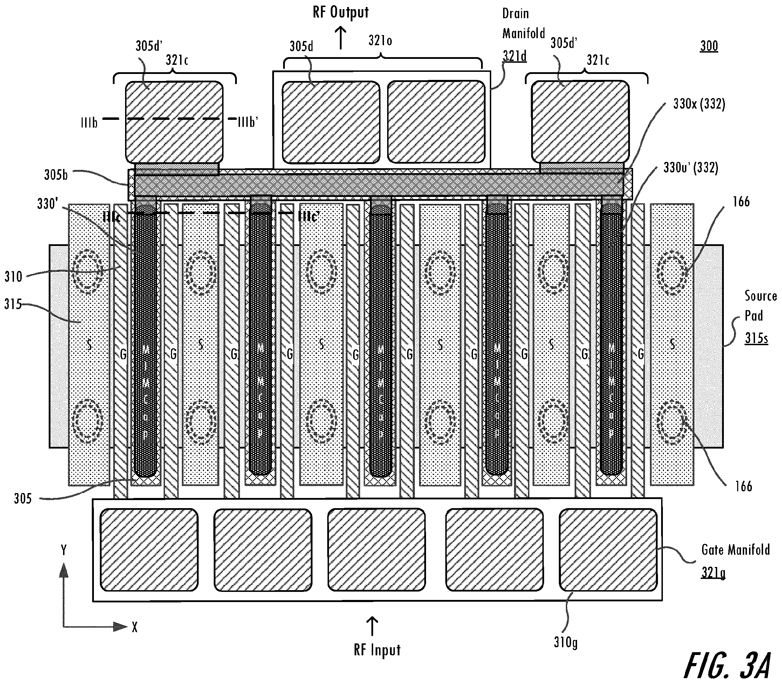

FIG. 3A is a schematic plan view of a RF transistor die or device 300 including on-chip capacitors 330 integrated on internal portions of the drain manifold 321d that extend between gate fingers G according to some embodiments of the present disclosure. As shown in FIG. 3A, the drain manifold 321d includes two sections 321o and 321c. The first section 321o includes the output bond pads 305d, which provide a direct electrical connection to a first metal layer 331 (e.g., M1) of the drain manifold 321d. The output bond pads 305d in the first section 321o may be used to provide a DC coupled path for bias and/or shunt element connection. The second section 321c includes bond pads 305d' that are connected by a crossover connector 330x to on-chip capacitors 330' (shown as MIMCAPs, each including an upper plate 330u', a dielectric layer 333, and a lower plate 3301') on internal portions of the drain manifold 321d that extend over the plurality of drain fingers D, between respective gate fingers G.

In the example of FIG. 3A, portions of a second metal layer 332 (e.g., M2) provide respective upper plates 330u' of the capacitors 330, portions of the first metal layer 331 (not visible in FIG. 3A) provide respective lower plates 3301' of the capacitors, with respective dielectric layers 333 (not visible in FIG. 3A) between the upper plates 330u' and the lower plates 3301'. The upper plates 330u' are electrically coupled to the bond pads 305d' by the crossover connector 330x (which may also be implemented by portions of the second metal layer 332 in some embodiments). The upper plates 330u' (and/or the bond pads 305d' electrically connected thereto) may provide for direct connection to the capacitors 330', and the lower plates 3301' may be electrically connected to respective drain fingers D, providing a series capacitance at the RF output of the transistor die 300.

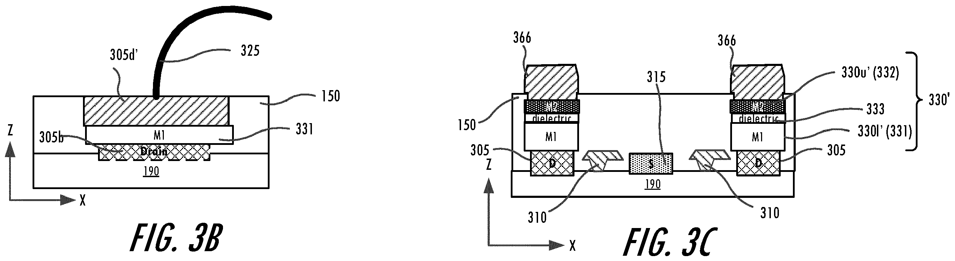

The capacitors 330' are thus integrated on the internal portion of the drain manifold 321d that extends between the gate fingers G, such that the drain manifold 321d provides bond pads 305d' for connections to the capacitors 330' in the second section 321c, while the first section 321o provides the output bond pads 305, e.g., for bias connections. In the example of FIG. 3A, the drain manifold 321d includes a first portion (i.e., the bond pad area) that extends adjacent a periphery of the active region of the semiconductor structure 190, and a second portion that extends over the active region of the semiconductor structure 190, in particular, along the respective drain fingers D and between pairs of gate fingers G. The on-chip capacitors 330' are thus stacked on or vertically overlapping with the active region between adjacent gate fingers G, as shown in the cross section of FIG. 3C.

The configuration shown in FIG. 3A may be advantageous in that the series capacitors 330' are positioned as close as possible to the active channel region between the source 315 and drain 305 of the transistors 10 (as shown in FIG. 3C), further reducing inductance, while using bond pads 305d' that are similar to the output bond pads 305d. The position and/or size of the drain manifold 321d, each section 321o, 321c thereof, and/or the number of capacitor(s) 330' thereon (and thus the collective capacitance value provided thereby) may vary in accordance with embodiments of the present disclosure to provide a desired capacitance and/or routing of connections.

FIGS. 3B and 3C are schematic cross sectional views taken along lines IIIb-IIIb' and IIIc-IIIc' of FIG. 3A, respectively, illustrating examples of electrical connections to on-chip capacitors 330' according to some embodiments of the present disclosure. In the examples of FIGS. 3B and 3C, the on-chip capacitors 330' each include a lower plate 3301', an upper plate 330u', and a dielectric layer 333 therebetween, with the lower plate 3301' implemented by portions of a first metal layer 331 on the semiconductor structure 190, and the upper plate 330u' implemented by portions of a second metal layer 332 on the semiconductor structure 190. The capacitors 330' are configured for electrical connection to an external (or "off-chip") device using wirebonds 325 and/or conductive pillars 366.

For example, as shown in FIG. 3B, a wirebond 325 may be directly bonded to the bond pads 305d', which are coupled to the upper plate 330u' of the capacitor 330' by the crossover connector 330x implemented by portions of the first metal layer 331. Additionally or alternatively, as shown in FIG. 3C, conductive pillars 366 can be coupled directly to the upper capacitor plates 330u' of the capacitor 330' that extend on the internal portions of the drain manifold 321d, which are implemented by portions of the first metal layer 331 that extend over the drain fingers D on the active region of the die 300, between the gate fingers G. Providing the conductive pillars 366 coupled to the upper capacitor plate 330u' on the active region may allow for implementation of a larger number of pillars 366 (in comparison to providing conductive pillars 366 primarily on the bond pad area), which can support higher current. Alternatively, fewer conductive pillars 366 can be used to reduce overall die size.

The electrical connections shown in FIGS. 3B and 3C may be used to implement on-chip matching and/or harmonic termination (e.g., shunt) circuits in some embodiments. For example, a series inductance may be coupled to the capacitor 330' to provide an LC circuit at the RF output of the transistor die for matching and/or harmonic termination. The series inductance may be implemented by a wirebond 325 coupled to the output bond pad 305d' (as shown in FIG. 3B) or the conductive pillar 366 coupled directly to the upper capacitor plate 330u' implemented by portions of the second metal layer 332 (as shown in FIG. 3C), either or both of which may be configured to provide a desired inductance value. The wirebonds 325 may be routed relative to the direction of extension of the fingers G, D, S so as to provide an orthogonal shunt inductance, which may reduce coupling with series inductances.

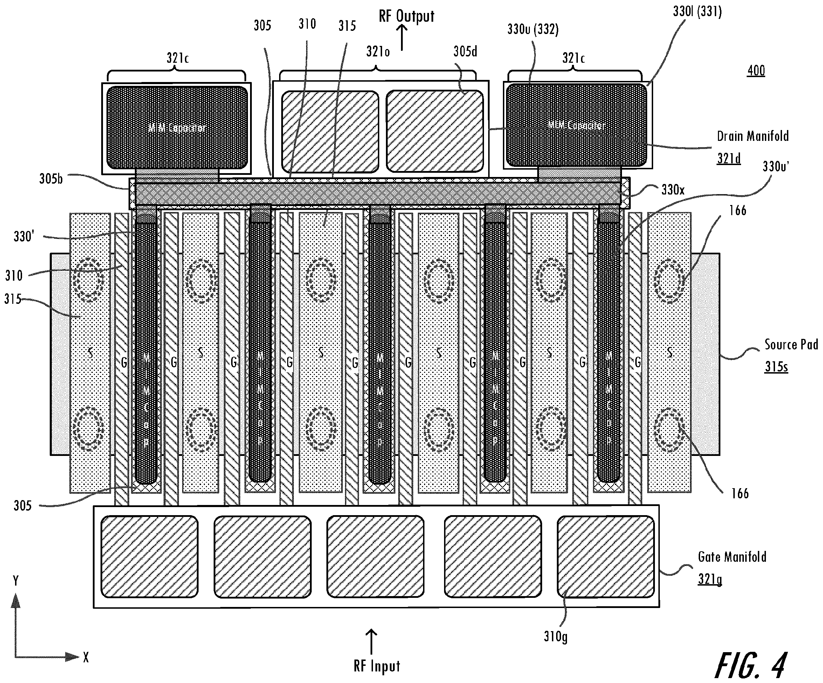

FIG. 4 is a schematic plan view of a RF transistor die or device 400 including on-chip capacitors 330, 330' integrated on the drain manifold 321d at both the peripheral portions (i.e., the bond pad area adjacent a periphery of the active region of the transistor die 400) and the internal portions (i.e., the portions that extend over the active region of the die 400 along the respective drain fingers D between pairs of gate fingers G) according to some embodiments of the present disclosure. The capacitors 330 are integrated on a first (peripheral) portion of the drain manifold 321d with the upper plate 330u, the lower plate 3301, and the dielectric layer 333 therebetween stacked adjacent a periphery of the active region on or adjacent the output bond pads 305d, while the capacitors 330' are integrated on a second (internal) portion of the drain manifold 321d with the upper plate 330u', the lower plate 3301', and the dielectric layer 333 therebetween stacked on the drain fingers D between the gate fingers in the active region.

The upper plate 330u may provide a bond pad for direct connection to a respective capacitor 330, and the lower plate 3301 may be electrically connected to the drain (e.g., to the drain bus 305b), providing a series capacitance at the RF output terminal. The upper plates 330u' may provide for direct connection to the capacitors 330', and the lower plates 3301' may be electrically connected to respective drain fingers D, also providing a series capacitance at the RF output. As the upper plates 330u, 330u' may be electrically connected (e.g., implemented by respective portions of the second metal layer 332), and the lower plates 3301, 3301' may be electrically connected (e.g., implemented by respective portions of the first metal layer 331), the capacitors 330 and 330' may be electrically connected in parallel, such that their respective capacitance values are added to provide a desired capacitance. That is, the two MIMCAP layouts shown in FIGS. 2A and 3A can be combined to increase the total series capacitance, while reducing or maintaining minimal pitch between the gate fingers G. Wirebond 325 and/or conductive pillar 366 connections to the upper capacitor plates 330u, 330u' may be similarly provided as described above with reference to FIGS. 2B to 2E and 3B to 3C.

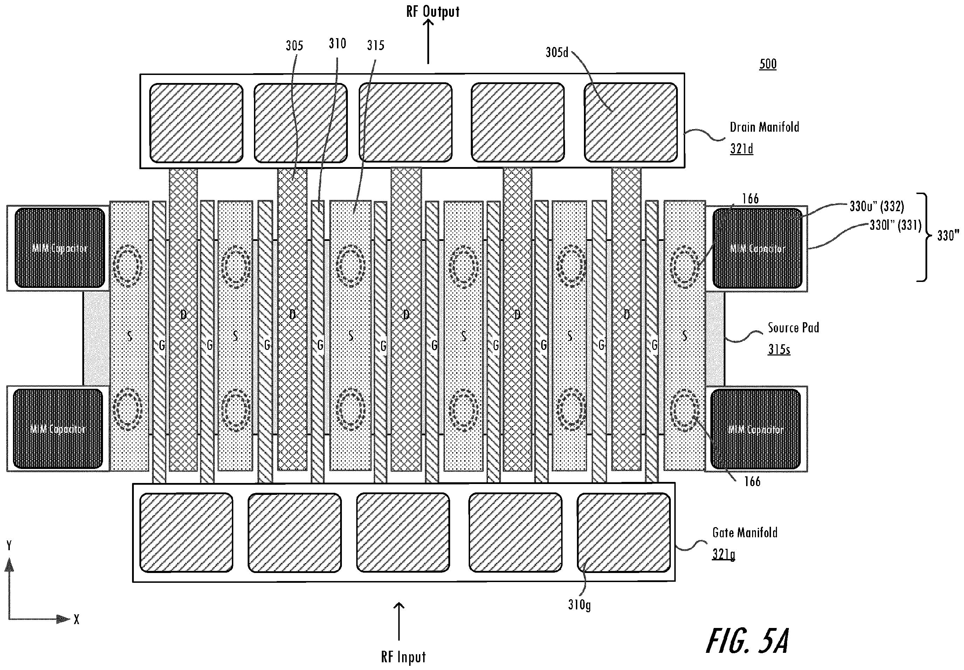

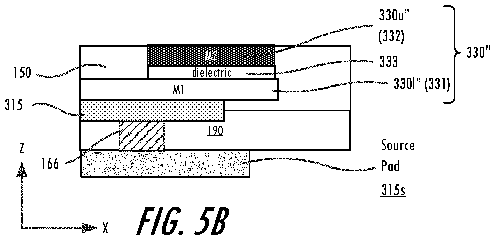

FIG. 5A is a schematic plan view of a RF transistor die or device 500 including on-chip capacitors 330" (shown as MIMCAPs) integrated on edges or corner portions of the die 500 (e.g., adjacent a periphery of the active regions) and electrically connected to the source pad 315s according to some embodiments of the present disclosure. FIG. 5B is a schematic cross sectional view taken along lines V-V' of FIG. 5A. In the example shown in FIGS. 5A and 5B, the upper capacitor plates 330u" can be implemented by portions of the second metal layer 332 on the edges or corners of a die 500 adjacent the source fingers S, with the lower capacitor plate 3301" implemented by portions of the first metal layer 331 (which may be electrically isolated from other portions of the first metal layer 331 that provide the manifolds 321g or 321d). The lower plate 3301" of a respective capacitor330" can be electrically coupled to a source finger S or otherwise electrically coupled to the source pad 315s by the source vias 166. The upper plate 330u" of a respective capacitor 330" may provide a bond pad for electrical connection (e.g., by wirebond 325, conductive pillar 366, or other elements) to provide a shunt connection to ground, at the RF output and/or at the RF input.

For example, the capacitors 330" (with the wirebond 325, conductive pillar 366, or other elements providing respective inductances) may be used to implement shunt LC elements for harmonic resonant structures. In particular, the capacitor 330" may implement a shunt capacitance by using the source via 166 to electrically ground the lower capacitor plate 3301". The shunt capacitor 330" may be used to implement on-chip matching circuits at the RF input and/or at the RF output. Also, a wirebond 325, conductive pillar 366, or other elements can be used to couple the upper capacitor plate 330u" to the RF input and/or the RF output to provide shunt inductance decoupling. That is, the capacitors 330" may be connected by wirebond, conductive pillar, or other connection (including on chip transmission line or spiral inductor) to provide a shunt connection to ground at either the RF output or RF input of the die 500.

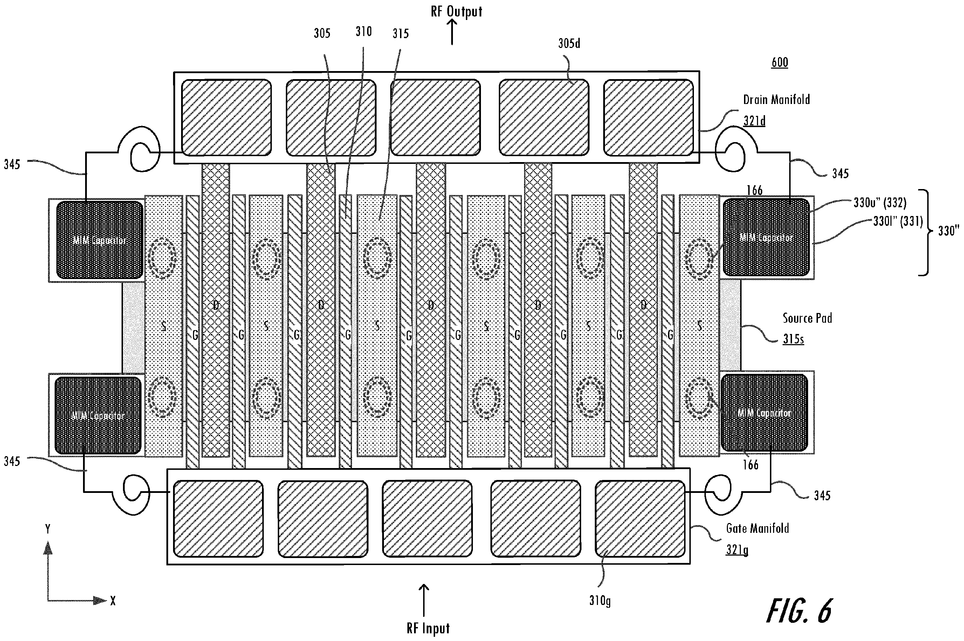

FIG. 6 is a schematic plan view of a RF transistor die or device 600 including on-chip capacitors 330" integrated on edges or corner portions of the die 600 (as shown in FIG. 5) and respectively connected to the gate manifold 321g or the drain manifold 321d pad by inductance elements 345 according to some embodiments of the present disclosure. The inductance elements 345 may be implemented by wire bonds or other connections, such as on chip-transmission lines (e.g., inductors defined by spiral RF transmission lines or meandered RF transmission line segments).

As shown in FIG. 6, a lower plate 3301" of a respective capacitor 330" is coupled to the source pad 315s, and an upper plate 330u" of the capacitor 330" is connected to the input or output bond pad area 321g or 321d by respective inductance elements 345 to provide on-chip impedance matching and/or harmonic termination circuits described herein. As such, the upper plates 330u" of the respective capacitors 330" can be connected directly to the gate 321g or drain 321d bond area by the inductance elements 345 to provide portions of the LC circuits for an input or output shunt connection. The capacitor 330" (which provides a shunt capacitance, using the source via 166 as a ground connection) and the inductance element 345 implement a resonator, which may allow for improved VBW. The upper plates 330u" of the respective capacitors 330" can also be connected to off-chip component or circuit elements.

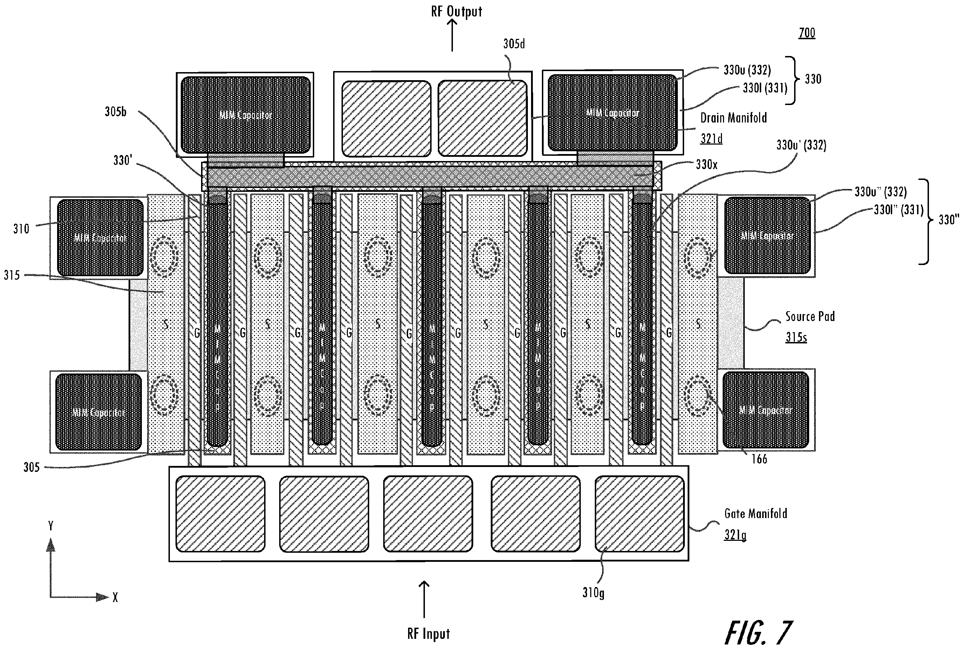

FIG. 7 is a schematic plan view of a RF transistor die or device 700 including on-chip capacitors 330, 330", 330" integrated on peripheral portions of the drain manifold 321d (adjacent or outside the active region of the die, as shown in FIG. 2A), on internal portions of the drain manifold 321d (on the active region of the die between gate fingers G, as shown in FIG. 3A), and on edges or corner portions of the die 700 (as shown in FIG. 5) according to some embodiments of the present disclosure. That is, shunt capacitors 330" of FIGS. 5 (as well as the inductance elements 345 of FIG. 6) can be implemented in various combinations with the series capacitors 330 and/or 330" of FIGS. 2A and/or 3A.

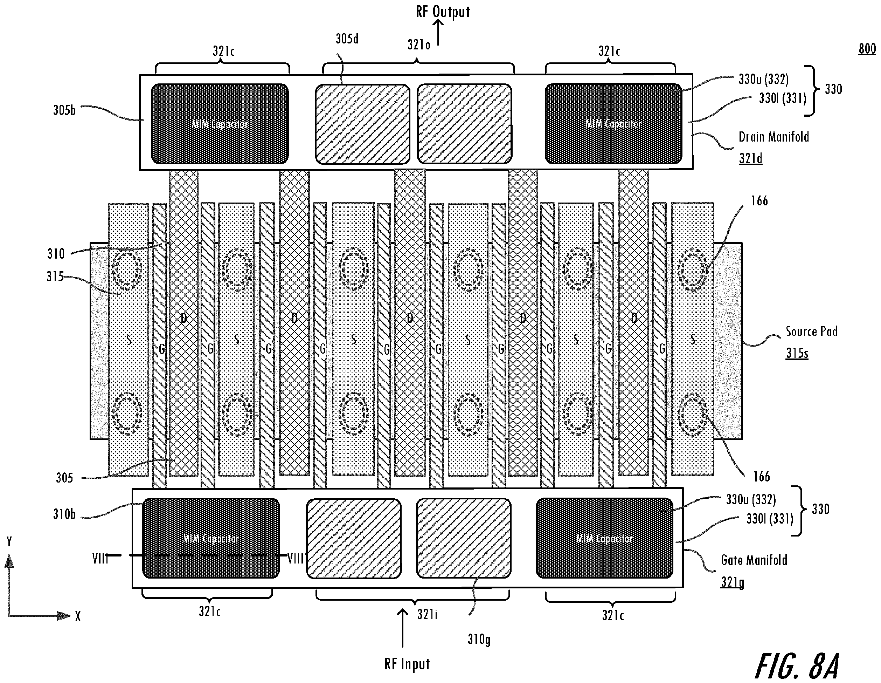

FIG. 8A is a schematic plan view of a RF transistor die or device 800 including on-chip capacitors 330 integrated on the gate pads 310g or manifold 321g and on the drain pads 305d or manifold 321d (as shown in FIG. 2A) according to some embodiments of the present disclosure.

In combination with (or in some embodiments, independently of) the drain-side series capacitors 330 described above with reference to the die 200 of FIG.2A, the transistor die 800 of FIG. 8A includes a gate manifold 321g having two sections 321i and 321c. The first section 321i (also referred to as an input bond pad area) includes the input bond pads 310g, which provide a direct electrical connection to a first metal layer 331 (e.g., M1) of the gate manifold 321g. The input bond pads 310g may be used to provide a DC coupled path for bias and/or shunt element connections. The second section 321c includes one or more on-chip capacitors 330 (shown as MIMCAPs, each including an upper plate 330u, a dielectric layer 333, and a lower plate 3301), where portions of a second metal layer 332 (e.g., M2) provide the respective upper plates 330u of the capacitors 330, portions of the first metal layer 331 provide the respective lower plates 3301 of the capacitors, with the respective dielectric layers 333 (not visible in FIG. 8A) between the upper plates 330u and the lower plates 3301. The upper plate 330u may provide (or may be electrically coupled to) a bond pad for direct connection to a respective capacitor 330, and the lower plate 3301 may be electrically connected to the gate (e.g., to the gate bus 310b), providing a series capacitance at the RF input terminal of the transistor die 800.

The capacitors 330 are thus integrated on the gate manifold 321g, such that the gate manifold 321g provides a lower plate 3301 of the capacitors 330 in the second section 321c, while the first section 321o provides the input bond pads 310g. That is, in the die 800 of FIG. 8A, the series capacitors 330 implemented on the output bond pads 305d or drain manifold 321d in FIG. 2A can be similarly implemented on the input bond pads 310g or gate manifold 321g. As the gate manifold 321g extends adjacent a periphery of the active region of the semiconductor structure 190, the on-chip capacitors 330 are stacked adjacent a periphery of the active region, on or adjacent the input bond pads 310g. However, the capacitors 330 may extend onto (or may be confined outside of) the active region in some embodiments. More generally, the position and/or size of the gate manifold 321d, each section 321i, 321c thereof, and/or the number of capacitor(s) 330 thereon (and thus the collective capacitance value provided thereby) may vary in accordance with embodiments of the present disclosure to provide a desired capacitance and/or routing of connections.

Moreover, while FIG. 8A illustrates on-chip capacitors 330 integrated at both the input and the output of the die 800, it will be understood that in some embodiments the on-chip capacitors 330 may be implemented on the gate manifold 321g/bond pads 310g only, rather than on both the gate manifold 321g and on the drain manifold 321d. Likewise, on-chip capacitors 330' and/or 330" as described herein may be implemented in any combination with the on-chip capacitors 330 at the input and/or at the output of the die 800. Providing the series capacitance 330 at the RF input and/or RF output terminals of the die 800 may offer advantages, for example, with respect to compactness and low value capacitance implementation suitable for input (e.g., gate)-side matching circuits.

FIGS. 8B, 8C, 8D, and 8E are schematic cross sectional views taken along line VIII-VIII' of FIG.8A, illustrating examples of wirebond or conductive pillar connections to on-chip capacitors 330 electrically coupled in series with an RF input terminal of a transistor die 800 according to some embodiments of the present disclosure. In FIGS. 8B to 8E, the on-chip capacitors 330 may each include a lower plate 3301, an upper plate 330u, and a dielectric layer 333 therebetween. In the examples of FIGS. 8B to 8E, the lower plate 3301 is implemented by portions of a first metal layer 331 on the semiconductor structure 190, and the upper plate is implemented by portions of a second metal layer 332 on the semiconductor structure 190. The capacitors 330 are configured for electrical connection to an external (or "off-chip") device using wirebonds 325 and/or conductive pillars 366.

For example, a wirebond 325 may be directly bonded to the upper plate 330u of the capacitor 330 as shown in FIG. 8B, or may be bonded to an extension pad 330e (or an adjacent bond pad 310g) that is an electrically connected to the upper plate 330u, as shown in FIG. 8D. Additionally or alternatively, a conductive pillar 366 or other type of integrated connector may be directly bonded to the upper plate 330u of the capacitor 330 as shown in FIG. 8C, or may be bonded to an extension pad 330e that is an electrically connected to the upper plate 330u, as shown in FIG. 8E. The extension pad 330e may be implemented by a portion of the second metal layer 332, and may be integral to the upper plate 330u in some embodiments. Embodiments described herein may include various combinations of conductive pillars 366 and wirebond 325 connections.

As noted above with respect to the series output capacitance in FIG. 2A, bonding directly to the upper plate 330u of the capacitor 330 providing the input capacitance (whether by wirebond 325 or conductive pillar 366) may allow for fewer bond pads, thereby reducing device size and cost, while the conductive pillar connections 366 shown in FIGS. 8C and 8E may allow for mounting of transistor dies described herein in a "flip-chip" configuration without bond wires, which may reduce inductance and associated parasitic effects relating to the package and connections.

The electrical connections shown in FIGS. 8B to 8E, may be used to implement on-chip matching and/or harmonic termination (e.g., shunt) circuits at the RF input terminal of the die 800 in some embodiments. For example, a series inductance may be coupled to the capacitor 330 to provide an LC circuit at the RF input of the transistor die 800 for matching and/or harmonic termination. The series inductance may be implemented by a wirebond 325 (as shown in FIGS. 8B and 8D) or a conductive pillar 366 (as shown in FIGS. 8C and 8E), either directly to the upper plate 330u (as shown in FIGS. 8B and 8C) or to the extension pad 330e (as shown in FIGS. 8D and 8E).

Providing on-chip capacitors 330 on the input side may be advantageous with respect device compactness, particularly in implementing a DC blocking capacitor 330 coupled to the gate 310g/321g, which may have a relatively low capacitance value, allowing for implementation of a more compact input matching circuit than some conventional low pass networks. More generally, in FIGS. 2A to 8E, electrical connections to the upper capacitor plates 330u, 330u', 330u" can be by wirebonds 325 or conductive pillars 366, directly to the upper capacitor plates 330u, 330u', 330u" or to an electrically connected extension area 330e, to provide series and/or shunt capacitance at the input and/or at the output of the transistor dies 200 to 800.

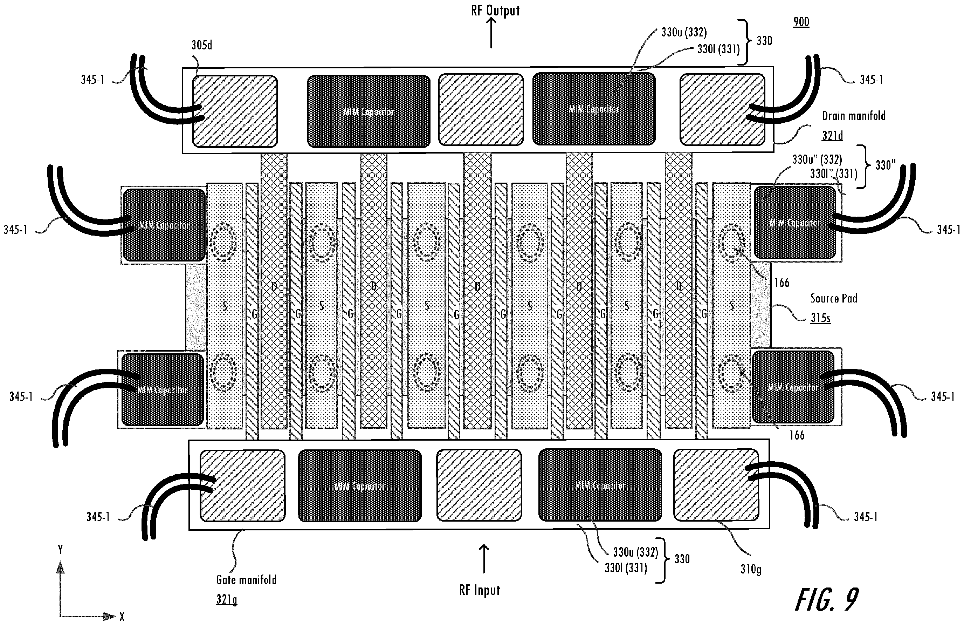

FIG. 9 is a schematic plan view of a RF transistor die or device 900 including on-chip series capacitors 330 integrated on both the gate manifold 321g and the drain manifold 321d (as shown in FIG. 8), in combination with on-chip shunt capacitors 330" integrated on edges or corner portions (as shown in FIG. 5) of the transistor die 900 and electrically connected to the gate pad 310g or the drain pad 305d by inductance elements 345 (as shown in FIG. 6) according to some embodiments of the present disclosure. That is, shunt capacitors 330" of FIG. 5 and the inductance elements 345 of FIG. 6 can be implemented in various combinations with the series capacitors 330 of FIG. 8A.

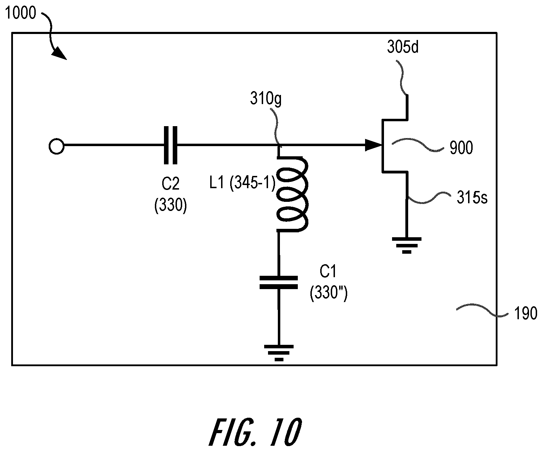

As shown in FIG. 9, a lower plate 3301" of a capacitor 330" (which may be provided by portions of a first metal layer 331) is electrically coupled to the source pad 315s, and an upper plate 330u" of the capacitor 330" (which may be provided by portions of a second metal layer 332) is connected to the input bond pads 310g or output bond pads 305d by inductance elements 345-1. The inductance elements 345-1 can thereby provide a shunt inductance (L1 in FIG. 10) and the capacitor 330" provides a shunt capacitance (C1 in FIG. 10) at the RF input terminal of the transistor die 900 (and similarly at the RF output terminal of the transistor die 900). In some embodiments, the inductance elements 345-1 may be routed substantially perpendicular to the direction of extension of the fingers G, D, S so as to provide an orthogonal shunt inductance, which may reduce coupling with series inductances.

Still referring to FIG. 9, a lower plate 3301 of a capacitor 330 (which may be provided by portions of the first metal layer 331) is integrated on (or otherwise electrically coupled to) the gate manifold 321g, and an upper plate 330u of the capacitor 330 (which may be provided by portions of the second metal layer 332) provides a bond pad for connection to inductance element 345-2. The capacitors 330 can provide a series capacitance (C2 in FIG. 10) at the RF input terminal of the transistor die 900 (and similarly at the RF output terminal of the transistor die 900).

The input bond pads 310g and/or output bond pads 305d may thereby provide a DC coupled path for bias and shunt element connections. That is, shunt capacitors 330" can be implemented in combination with series capacitors 330, and coupled (by inductance elements 345-1, 345-2) to the input 321g and/or output 321d terminals of the transistor die 900. The inductance elements 345-1, 345-2 (collectively 345) are illustrated as wire bonds, but may be implemented by other connections, such as on chip-transmission lines (e.g., spiral RF transmission lines or meandered RF transmission line segments on the semiconductor structure 130 of the transistor die 900).

More generally, in the embodiments of FIGS. 2A to 9, series inductance (whether implemented by wirebond 325, conductive pillar 366, or other connection element, including on-die transmission lines or spiral inductors 345) may be coupled to one or more capacitor 330, 330', 330" to provide respective LC circuits at the RF input, RF output, and/or ground terminal of the transistor die for input, output, and/or inter-stage on-die impedance matching and/or harmonic termination circuits.

FIG. 10 is an equivalent circuit diagram of the gate connections of FIG. 9, illustrating an input matching circuit 1000 implemented by on-chip series capacitors 330 and shunt capacitors 330" and inductance elements 345 according to some embodiments of the present disclosure.

As shown in FIG. 10, the input matching circuit 1000 includes a first shunt inductance element L1 (345-1) that is on the semiconductor structure 190 and is electrically coupled to a gate terminal of the transistor die 900, and a first capacitor C1 (330") that is on the semiconductor structure 190 adjacent the active region and electrically couples the first shunt inductance element L1 (345-1) to an electrical ground (to which the source terminal of the transistor die 900 is also coupled). A second capacitor C2 (330) is on the semiconductor structure 190 adjacent the active region and is electrically coupled in series with the gate terminal. The input matching circuit 1000 thus includes one or more high pass sections (e.g., L1/C1) that may be partially or entirely implemented on the semiconductor structure 190 of the transistor die 900, which may improve stability.

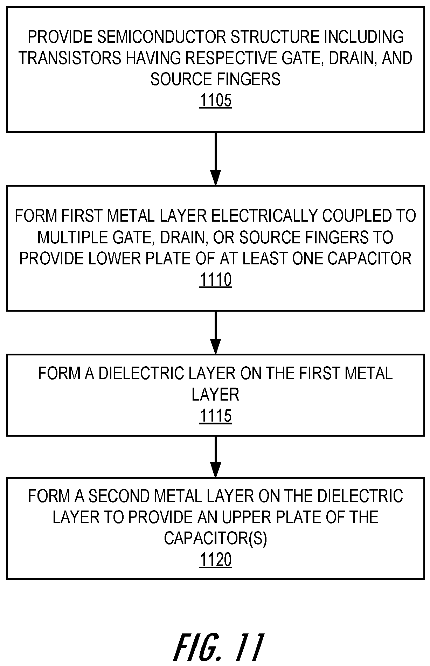

FIG. 11 is a flowchart illustrating methods of fabricating an RF transistor die according to some embodiments of the present invention. As shown in FIG. 11, a semiconductor structure comprising a plurality of transistors having respective gate, drain, and source fingers is provided at block 1105. At block 1110, a first metal layer (e.g., M1 metallization) is formed on the semiconductor structure. The first metal layer is electrically coupled to a plurality of the respective gate, drain, or source fingers (e.g., by a conductive bus or manifold). The first metal layer may provide a lower plate of one or more capacitors. The lower plate of the capacitor(s) may be electrically connected to one or more of the gate, drain, or source fingers. A dielectric layer is formed on the first metal layer at block 1115. The dielectric layer may be a same material as (or may be a portion of) an interlayer insulating layer or passivation layer formed on the semiconductor structure. The dielectric layer may be formed with a thickness t of about 0.01 µm to about 1.5 µm, for example, about 0.1 µm to about 1 µm. At block 1120, a second metal layer (e.g., M2 metallization) is formed on the dielectric layer. The second metal layer may provide an upper plate of one or more capacitors. Conductive connections (e.g., wirebonds or conductive pillars) may be formed on the upper plate of the capacitor(s), or on conductive extension elements or pads electrically connected thereto.

The capacitor(s) defined by respective portions of the first metal layer, the second metal layer, and the dielectric layer therebetween may thus be integrated on the semiconductor structure itself, and may provide portions of on-die matching and/or harmonic termination circuits. The on-chip gate or drain manifold capacitors (e.g., 330) or the on-chip shunt capacitors (e.g., 330") may be configured to provide a capacitance ranging from about 0.1 to about 50 pF, for example about 0.2 to about 30 pF. The on-chip drain finger capacitors (e.g., 330') may be configured to provide a capacitance ranging from about 0.01 to about 2 pF, for example about 0.05 to about 1 pF.

Embodiments of the present disclosure may be used in various transistor dies, and in general in any application where a reduction in size and/or parasitic series inductance is desired. In some embodiments, at the RF output, a series capacitor and/or access to bias (e.g., through shunt inductance) may be provided directly on (or as close as possible to) the drain terminal of a FET.

Referring again to FIGS. 1A and 1B, the transistor die 100 includes a semiconductor structure 190, such as a semiconductor structure for a Group III nitride or other wide bandgap semiconductor HEMT or MOSFET, on a substrate 132, such as a silicon carbide or sapphire substrate. For example, the substrate 132 may be a silicon carbide wafer, and the device 100 may be formed, at least in part, via wafer level processing, and the wafer may then be diced to provide a device 100 including plurality of individual unit cell transistors (respectively designated herein as 10). In some embodiments, the thickness of the substrate 132 (e.g., in a vertical or Z direction in FIG. 1B) may be greater than 100 µm, greater than 200 µm, or greater than 400 µm.In some embodiments, the transistor structure 10 may include a thinned substrate 132. In some embodiments, the substrate 132 may be thinned to a thickness (e.g., in the vertical or Z direction) of about 100 µm or less, e.g., 75 µm or less or 50 µm or less. The substrate 132 may be described as being included in the semiconductor structure 190 in some embodiments.

The substrate 132 may be a semi-insulating silicon carbide substrate that may be, for example, the 4H polytype of silicon carbide. Other silicon carbide candidate polytypes may include the 3C, 6H, and 15R polytypes. In some embodiments of the present disclosure, the silicon carbide bulk crystal of the substrate 132 may have a resistivity equal to or higher than about 1×10⁵ ohm-cm at room temperature. It is to be understood that, although silicon carbide may be employed as a substrate 132, embodiments of the present disclosure may utilize any suitable substrate for the substrate 132, such as sapphire (Al₂O₃), aluminum nitride (AlN), aluminum gallium nitride (AlGaN), gallium nitride (GaN), silicon (Si), GaAs, LGO, zinc oxide (ZnO), LAO, indium phosphide (InP), and the like.

The semiconductor structure 190 is formed on a surface of the substrate 132 (or on the optional layers described further herein). In the illustrated examples, the semiconductor structure 190 is a wide bandgap semiconductor material formed by epitaxial growth, and thus includes one or more epitaxial layers 134, 136 (shown as a channel layer 134 and a barrier layer 136 of a HEMT device). While semiconductor structure 190 is shown with reference to one or more epitaxial layers 134, 136 for purposes of illustration, semiconductor structure 190 may include additional layers/structures/elements such as a buffer and/or nucleation layer(s) on or between substrate 132 and the one or more epitaxial layers 134, 136, and/or a cap layer on an upper surface of the epitaxial layer 136. For example, an AlN buffer layer may be formed on the upper surface of the substrate 132 to provide an appropriate crystal structure transition between the silicon carbide substrate 132 and the remainder of the layers 134, 136 of the semiconductor structure 190. Additionally, strain balancing transition layer(s) may also and/or alternatively be provided. The optional buffer/nucleation/transition layers may be deposited by metal-organic chemical vapor deposition (MOCVD), molecular beam epitaxy (MBE), and/or hydride vapor phase epitaxy (HVPE).

Still referring to FIGS. 1A and 1B, at the frontside 100f of the die 100, a source contact 315 and a drain contact 305 may be formed on a surface 136A of the epitaxial layer 136 and may be laterally spaced apart from each other. The source region of the unit cell transistor 10 is the portion of the semiconductor structure 190 that is directly underneath the source contact 315, and the drain region of the unit cell transistor 10 is the portion of the semiconductor structure 190 that is directly underneath the drain contact 305. A gate contact 310 may be formed on the epitaxial layer 136 between the source contact 315 and the drain contact 305. The material of the gate contact 310 may be chosen based on the composition of the epitaxial layer 324, and may, in some embodiments, be a Schottky contact. Some materials capable of making a Schottky contact to a Group III nitride based semiconductor material may be used, such as, for example, nickel (Ni), platinum (Pt), nickel silicide (NiSiₓ), copper (Cu), palladium (Pd), chromium (Cr), tungsten (W) and/or tungsten silicon nitride (WSiN). The gate, drain, and source contacts 310, 305, and 315 may provide gate, drain, and source terminals of each unit cell transistor 10, respectively.

The source contact 315 and/or the drain contact 305 may include a metal that can form an ohmic contact to a Group III nitride based semiconductor material. Suitable metals may include refractory metals, such as Ti, W, titanium tungsten (TiW), silicon (Si), titanium tungsten nitride (TiWN), tungsten silicide (WSi), rhenium (Re), Niobium (Nb), Ni, gold (Au), aluminum (Al), tantalum (Ta), molybdenum (Mo), NiSiₓ, titanium silicide (TiSi), titanium nitride (TiN), WSiN, Pt and the like. Thus, the source contact 315 and/or the drain contact 305 may contain an ohmic contact portion in direct contact with the epitaxial layer 136 (e.g., the barrier layer in a HEMT device).

In some embodiments, the transistor cell 10 may be a HEMT structure, and the semiconductor structure 190 may be an epitaxial layer structure including a channel layer 134 formed on a surface of the substrate 132 and a barrier layer 136 formed on a surface of the channel layer 134. The channel layer 134 may have a bandgap that is less than the bandgap of the barrier layer 136 and the channel layer 134 may also have a larger electron affinity than the barrier layer 136. The channel layer 134 and the barrier layer 136 may include Group III-nitride based materials. As discussed above with respect to the conventional HEMT device, a 2DEG layer is induced in the channel layer at a junction between the channel layer and the barrier layer. The 2DEG layer acts as a highly conductive layer that allows conduction between the source and drain regions of the device that are beneath the source contact 315 and the drain contact 305, respectively.

While not shown in FIG. 1B, the transistor cell 10 may further include one or more dielectric or insulating layers adjacent the frontside 100f. One or more of the insulating layers may serve as passivation layers for the transistor structure 10. The insulating layers may be dielectric material, such as silicon nitride (SiₓN_{y}), aluminum nitride (AlN), silicon dioxide (SiO₂), silicon oxynitrides, and/or other suitable protective material, for example, magnesium oxide, scandium oxide, aluminum oxide and/or aluminum oxynitride. More generally, the insulating layers may be a single layer or may include multiple layers of uniform and/or nonuniform composition, and/or may be sufficiently thick so as to protect the underlying epitaxial layer(s) 134, 136 during a subsequent anneal of ohmic contacts (e.g., to provide the source contacts 315 and/or the drain contacts 305).

Respective metal contacts may be formed to extend through one or more of the insulating layer(s) to contact one or more of the contacts 305, 310, 315. For example, conductive metal may be formed on portions of the source contacts 315 and/or the drain contacts 305 exposed by the insulating layers to form the metal contacts. The metal contacts may directly contact one or more of the contacts 305, 310, 315 of the transistor cell 10 at the frontside 100f of the die 100. The metal contacts may be used to provide connections to the gate bus 310b, drain bus 305b, and/or a source bus. The metal contacts may contain metal or other highly conductive material, including, for example, copper, cobalt, gold, and/or a composite metal.

While embodiments have been described herein primarily with reference to Group III nitride- or GaN-based semiconductor devices (such as GaN on SiC devices) by way of example, it will be understood that embodiments of the present disclosure are not limited to any particular semiconductor material.

Various embodiments have been described herein with reference to the accompanying drawings in which example embodiments are shown. These embodiments may, however, be embodied in different forms and should not be construed as limited to the embodiments set forth herein. Rather, these embodiments are provided so that this disclosure is thorough and complete and fully conveys the inventive concept to those skilled in the art. Various modifications to the example embodiments and the generic principles and features described herein will be readily apparent. In the drawings, the sizes and relative sizes of layers and regions are not shown to scale, and in some instances may be exaggerated for clarity.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region, or substrate is referred to as being "on," "attached," or extending "onto" another element, it can be directly on the other element or intervening elements may also be present. In contrast, when an element is referred to as being "directly on" or "directly attached" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Elements illustrated by dotted lines may be optional in the embodiments illustrated.

Like numbers refer to like elements throughout. Thus, the same or similar numbers may be described with reference to other drawings even if they are neither mentioned nor described in the corresponding drawing. Also, elements that are not denoted by reference numbers may be described with reference to other drawings.

In the drawings and specification, there have been disclosed typical embodiments of the invention and, although specific terms are employed, they are used in a generic and descriptive sense only and not for purposes of limitation, the scope of the invention being set forth in the following claims.

The following numbered clauses illustrate additional examples.
1. A radio frequency (RF) transistor die, comprising:
   a semiconductor structure comprising an active region including a plurality of transistors having respective gate, drain, or source fingers;
   a manifold on the semiconductor structure that electrically couples a plurality of the respective gate, drain, or source fingers; and
   at least one capacitor on the manifold and/or on at least one of the respective gate, drain, or source fingers.
2. The RF transistor die of Clause 1, further comprising:
   RF input, RF output, and ground terminals on the semiconductor structure, wherein one of the RF input, RF output, and ground terminals is electrically connected to the manifold,
   wherein the at least one capacitor is electrically coupled in series with the respective one of the RF input, RF output or ground terminals free of a wirebond connection.
3. The RF transistor die of Clause 1, wherein the manifold comprises a portion of a metal layer on the semiconductor structure that provides one of an upper or lower plate of the at least one capacitor.
4. The RF transistor die of Clause 3, wherein the at least one capacitor comprises a dielectric layer having a thickness of about 0.01 to about 1 micrometer (µm) between the upper plate and the lower plate thereof.
5. The RF transistor die of Clause 2, wherein the manifold is a drain manifold that electrically couples the plurality of the respective drain fingers to the RF output terminal, and the at least one capacitor is electrically coupled in series with the RF output terminal.
6. The RF transistor die of Clause 5, wherein the at least one capacitor is on at least one of:
   a first portion of the drain manifold that extends adjacent a periphery of the active region; or
   a second portion of the drain manifold that extends over the active region along ones of the respective drain fingers.
7. The RF transistor die of Clause 2, wherein the manifold is a gate manifold that electrically couples the plurality of the respective gate fingers to the RF input terminal, and the at least one capacitor is electrically coupled in series with the RF input terminal.
8. The RF transistor die of Clause 1, wherein the manifold comprises a first metal layer on the semiconductor structure and provides a lower plate of the at least one capacitor, and wherein an upper plate of the at least one capacitor comprises a second metal layer on the manifold.
9. The RF transistor die of Clause 8, further comprising:
   one or more conductive pillars protruding from the upper plate of the at least one capacitor on the manifold.
10. The RF transistor die of Clause 8, wherein the upper plate of the at least one capacitor is configured to provide a wire bond pad on the manifold.
11. The RF transistor die of Clause 2, wherein the RF input or RF output terminal comprises one or more conductive bond pads on the manifold adjacent a periphery of the active region.
12. The RF transistor die of Clause 11, wherein the ground terminal comprises a source pad that is electrically coupled to the plurality of the respective source fingers, and the at least one capacitor comprises a shunt capacitor that is electrically coupled between the manifold and the source pad.
13. The RF transistor die of Clause 12, wherein the shunt capacitor comprises a lower plate that is electrically connected to the source pad, and an upper plate that is electrically connected to the one or more conductive bond pads on the manifold.
14. The RF transistor die of Clause 13, wherein a first metal layer on the semiconductor structure provides the lower plate of the shunt capacitor, and a second metal layer on the semiconductor structure provides the upper plate of the shunt capacitor.
15. The RF transistor die of Clause 13, further comprising:
   a shunt inductance element that electrically couples the upper plate of the shunt capacitor to the one or more conductive bond pads on the manifold.
16. The RF transistor die of Clause 15, wherein the shunt inductance element comprises one or more conductive transmission lines on the semiconductor structure.
17. The RF transistor die of Clause 2, wherein the at least one capacitor comprises:
   a first capacitor on the semiconductor structure electrically coupled between the RF input terminal and the ground terminal; and
   a second capacitor on the semiconductor structure and electrically coupled in series with the RF input terminal.
18. The RF transistor die of Clause 17, further comprising:
   a first shunt inductance element electrically coupled between the RF input terminal and the first capacitor.
19. A radio frequency (RF) transistor die, comprising:
   a semiconductor structure having first and second metal layers thereon and a dielectric layer between the first and second metal layers, the semiconductor structure comprising a plurality of transistors having respective gate, drain, and source fingers,
   wherein the first metal layer is on at least one of or electrically couples a plurality of the respective gate, drain, or source fingers and provides a lower plate of at least one capacitor, and the second metal layer provides an upper plate of the at least one capacitor.
20. The RF transistor die of Clause 19, wherein the dielectric layer has a thickness of about 0.01 to about 1 micrometer (µm) between the upper plate and the lower plate of the at least one capacitor.
21. The RF transistor die of Clause 19, wherein the lower plate is a drain manifold that electrically couples the plurality of the respective drain fingers to an RF output terminal on the semiconductor structure such that the at least one capacitor is on the drain manifold and electrically coupled in series with the RF output terminal.
22. The RF transistor die of Clause 21, wherein the at least one capacitor is on at least one of:
   a first portion of the drain manifold that extends adjacent a periphery of an active region of the semiconductor structure; or
   a second portion of the drain manifold that extends over the active region along respective ones of the drain fingers.
23. The RF transistor die of Clause 19, wherein the lower plate is a gate manifold that electrically couples the plurality of the respective gate fingers to an RF input terminal on the semiconductor structure such that the at least one capacitor is on the gate manifold and electrically coupled in series with the RF input terminal.
24. The RF transistor die of Clause 19, further comprising:
   one or more conductive pillars protruding from the upper plate of the at least one capacitor.
25. The RF transistor die of Clause 19, wherein the upper plate of the at least one capacitor is configured to provide a wire bond pad.
26. The RF transistor die of Clause 19, wherein the first metal layer comprises one or more conductive bond pads adjacent a periphery of an active region of the semiconductor structure that provide RF input or RF output terminals.
27. The RF transistor die of Clause 26, wherein the lower plate electrically couples the plurality of the respective source fingers to a ground terminal on the semiconductor structure such that the at least one capacitor comprises a shunt capacitor that is electrically coupled between the ground terminal and the one or more conductive bond pads.
28. The RF transistor die of Clause 27, further comprising:
   a shunt inductance element that electrically couples the upper plate of the shunt capacitor to the one or more conductive bond pads.
29. The RF transistor die of Clause 28, wherein the shunt inductance element comprises one or more conductive transmission lines on the semiconductor structure.
30. A method of fabricating a radio frequency (RF) transistor die, the method comprising:
   providing a semiconductor structure comprising a plurality of transistors having respective gate, drain, and source fingers;
   forming a first metal layer on the semiconductor structure, wherein the first metal layer is on at least one of or electrically couples a plurality of the respective gate, drain, or source fingers and provides a lower plate of at least one capacitor;
   forming a dielectric layer on the first metal layer; and
   forming a second metal layer on the dielectric layer, wherein the second metal layer provides an upper plate of the at least one capacitor.
31. The method of Clause 30, wherein the dielectric layer has a thickness of 0.01 to about 1 micrometer (µm) between the upper plate and the lower plate of the at least one capacitor.
32. The method of Clause 30, wherein the lower plate is a drain manifold that electrically couples the plurality of the respective drain fingers to an RF output terminal on the semiconductor structure such that the at least one capacitor is on the drain manifold and electrically coupled in series with the RF output terminal.
33. The method of Clause 32, wherein the at least one capacitor is on at least one of:
   a first portion of the drain manifold that extends adjacent a periphery of an active region of the semiconductor structure; or
   a second portion of the drain manifold that extends over the active region along respective ones of the drain fingers.
34. The method of Clause 30, wherein the lower plate is a gate manifold that electrically couples the plurality of the respective gate fingers to an RF input terminal on the semiconductor structure such that the at least one capacitor is on the gate manifold and electrically coupled in series with the RF input terminal.
35. The method of Clause 30, further comprising:
   providing one or more conductive pillars protruding from the upper plate of the at least one capacitor.
36. The method of Clause 30, further comprising:
   providing one or more wirebond connections to the upper plate of the at least one capacitor.
37. The method of Clause 30, wherein the first metal layer comprises one or more conductive bond pads adjacent a periphery of an active region of the semiconductor structure that provide RF input or RF output terminals.
38. The method of Clause 37, wherein the lower plate electrically couples the plurality of the respective source fingers to a ground terminal on the semiconductor structure such that the at least one capacitor comprises a shunt capacitor that is electrically coupled between the ground terminal and the one or more conductive bond pads.
39. The method of Clause 38, further comprising:
   providing a shunt inductance element that electrically couples the upper plate of the shunt capacitor to the one or more conductive bond pads.
40. The method of Clause 39, wherein the shunt inductance element comprises one or more conductive transmission lines on the semiconductor structure.

## Claims

1. A radio frequency (RF) transistor die, comprising:
a semiconductor structure comprising an active region including a plurality of transistors having respective gate, drain, or source fingers;
a manifold on the semiconductor structure that electrically couples a plurality of the respective gate, drain, or source fingers; and
at least one capacitor on the manifold and/or on at least one of the respective gate, drain, or source fingers.

2. The RF transistor die of Claim 1, further comprising:
RF input, RF output, and ground terminals on the semiconductor structure, wherein one of the RF input, RF output, and ground terminals is electrically connected to the manifold,
wherein the at least one capacitor is electrically coupled in series with the respective one of the RF input, RF output or ground terminals free of a wirebond connection.

3. The RF transistor die of Claim 1, wherein the manifold comprises a portion of a metal layer on the semiconductor structure that provides one of an upper or lower plate of the at least one capacitor.

4. The RF transistor die of Claim 3, wherein the at least one capacitor comprises a dielectric layer having a thickness of about 0.01 to about 1 micrometer (µm) between the upper plate and the lower plate thereof.

5. The RF transistor die of Claim 2, wherein the manifold is a drain manifold that electrically couples the plurality of the respective drain fingers to the RF output terminal, and the at least one capacitor is electrically coupled in series with the RF output terminal.

6. The RF transistor die of Claim 5, wherein the at least one capacitor is on at least one of:
a first portion of the drain manifold that extends adjacent a periphery of the active region; or
a second portion of the drain manifold that extends over the active region along ones of the respective drain fingers.

7. The RF transistor die of Claim 2, wherein the manifold is a gate manifold that electrically couples the plurality of the respective gate fingers to the RF input terminal, and the at least one capacitor is electrically coupled in series with the RF input terminal.

8. The RF transistor die of Claim 1, wherein the manifold comprises a first metal layer on the semiconductor structure and provides a lower plate of the at least one capacitor, and wherein an upper plate of the at least one capacitor comprises a second metal layer on the manifold.

9. The RF transistor die of Claim 8, further comprising:
one or more conductive pillars protruding from the upper plate of the at least one capacitor on the manifold.

10. The RF transistor die of Claim 8, wherein the upper plate of the at least one capacitor is configured to provide a wire bond pad on the manifold.

11. The RF transistor die of Claim 2, wherein the RF input or RF output terminal comprises one or more conductive bond pads on the manifold adjacent a periphery of the active region.

12. The RF transistor die of Claim 11, wherein the ground terminal comprises a source pad that is electrically coupled to the plurality of the respective source fingers, and the at least one capacitor comprises a shunt capacitor that is electrically coupled between the manifold and the source pad.

13. The RF transistor die of Claim 12, wherein the shunt capacitor comprises a lower plate that is electrically connected to the source pad, and an upper plate that is electrically connected to the one or more conductive bond pads on the manifold.

14. The RF transistor die of Claim 13, wherein a first metal layer on the semiconductor structure provides the lower plate of the shunt capacitor, and a second metal layer on the semiconductor structure provides the upper plate of the shunt capacitor.

15. The RF transistor die of Claim 13, further comprising:
a shunt inductance element that electrically couples the upper plate of the shunt capacitor to the one or more conductive bond pads on the manifold.

16. The RF transistor die of Claim 15, wherein the shunt inductance element comprises one or more conductive transmission lines on the semiconductor structure.

17. The RF transistor die of Claim 2, wherein the at least one capacitor comprises:
a first capacitor on the semiconductor structure electrically coupled between the RF input terminal and the ground terminal; and
a second capacitor on the semiconductor structure and electrically coupled in series with the RF input terminal.

18. The RF transistor die of Claim 17, further comprising:
a first shunt inductance element electrically coupled between the RF input terminal and the first capacitor.
